# EUROPEAN PATENT APPLICATION

(11) **EP 1 220 036 A1**
(43) Date of publication of application: **03.07.2002**
(21) Application number: 00911364.8
(22) Date of filing: 24.03.2000
(51) Int. Cl.: G03F 7/20

(54) **SUBSTRATE SUPPORTING TABLE OF EXPOSURE SYSTEM**

(30) Priority: 01.09.1999 JP 24724499
(71) Applicant: SANEI GIKEN CO., LTD., Amagasaki-shi, Hyogo 660-0805 (JP)
(72) Inventor: MIYAKE, Eiichi, Amagasaki-shi, Hyogo 660-0805 (JP)
(74) Representative: Prüfer, Lutz H., Dipl.-Phys.
(86) International application number: JP0001840
(87) International publication number: WO0116654

(57) **Abstract**

The board supporting stage is formed with three plate-shaped elements of first element (10), second element (20) and third element (30). Board suction holes (10a) are arranged in the first element (10) avoiding overlap with board through holes (12a) in the board (12). Thus, a board supporting stage eliminating the risk of suction of air via the board through holes, facilitating replacement of the elements constituting the stage, and having favorable board holding capability, is provided.

## Description

### Technical Field

The present invention relates to a board supporting stage for use in an exposure system that is employed in manufacture of, e.g., a print circuit board (hereinafter, referred to as "board") for forming a desired conductive pattern thereon.

### Background Art

In an exposure system wherein a photomask and a board are stacked one on another in proximity or in contact with each other and the board is irradiated with light through the photomask for transfer of a pattern drawn on the photomask onto the board, a stage for supporting the board is provided.

This board supporting stage is used to support the board flatwise, in parallel with the photomask. It has a board supporting plane provided with a large number of negative pressure suction holes to exert suction on the board for supporting thereof.

However, there are cases where the board itself has a great number of through holes. If a conventional board supporting stage is used for supporting such a board, the through holes of the board and the suction holes of the stage will overlap here and there. In this case, unwanted suction of air will occur through the board through holes.

Such suction via the board through holes will cause excessive air to flow into a negative pressure suction source connected to the suction holes of the board supporting stage. This leads to reduction of the negative pressure, and hence, weakening of the board supporting force by suction.

In addition, if the air is sucked in through the board through holes, at the time of alignment of the photomask and the board, or at the time when the photomask and the board are brought closer to each other for exposure, negative pressure will be developed in the gap between the photomask and the board. This causes a force to operate in a direction to make the photomask and the board further approach to each other, possibly making them contact to each other.

Methods conventionally proposed to solve such a problem includes the one to fill, with filler or the like, the negative pressure suction holes on the board supporting stage side that overlap the through holes on the board side. According to another method, a plurality of headers each having multiple negative pressure suction holes collected as a group, and a great number of suction systems for connecting the respective headers to a negative pressure suction source, are provided. For each suction system, opening/closing of valves is controlled to restrict the suction of air via the board through holes to a least possible level.

With such conventional methods, however, it is difficult to replace elements constituting the supporting stage in accordance with changes in types of the boards. It is also hard to completely solve the problem of suction solely by controlling the opening/closing of valves.

In addition, the boards are not necessarily flat. Warped or distorted boards may not be secured reliably.

The present invention has been made to solve the foregoing problems. The first object is to provide a board supporting stage that is reliable, easy to replace an element of the stage, and unlikely to cause suction of air via through holes provided in a board even if the type of the board having the through holes is changed. The second object is to provide a board supporting stage that guarantees secure holding of a board even if the board is distorted.

### Disclosure of the Invention

Namely, according to an aspect of the present invention, the board supporting stage for use in an exposure system for supporting a board on its plane in tight contact by exerting suction on the board via a large number of negative pressure suction holes provided on the plane has a structure formed of at least three flat-plate elements stacked one on another. A first element having its, upper surface contacting the board and a second element in contact with the under surface of the first element are each made of a flat plate having the negative pressure suction holes for exerting suction on the board in positions corresponding to each other.

The negative pressure suction holes of the first element are provided in regions where they are prevented from overlapping board through holes provided in the board, to suppress suction of air via the board through holes. Further, a third element is bonded to the under surface of the second element, and has a header function for collectively connecting the negative pressure suction holes of the first and second elements to a negative pressure suction source. The at least three flat-plate elements including the first, second and third elements constitute the board supporting stage for the exposure system.

Preferably, the negative pressure suction holes of the first element are formed using a dedicated driller or the like, upon input of data showing positions of the negative pressure suction holes provided in the second element, positions of the through holes formed in the board, and regions encircling the board through holes, based on output data obtained by executing on a general-purpose computer or a dedicated processor a program performing data processing for determining the positions where the negative pressure suction holes are to be formed in the first element.

Still preferably, a positioning element such as a pin or stopper is provided for alignment of the first and second elements, such that the negative pressure suction holes provided in the first element match in position with the corresponding negative pressure suction holes provided in the second element.

The first element is preferably a flat plate, sheet or film made of plastic. The second element is preferably formed of a plastic flat plate. The third element is preferably formed of an elastic body like rubber, and bonded to the second element with adhesive. With the board supporting stage for the exposure system having such a flexible structure, it is easy to establish, by negative pressure, tight contact between the photomask and the board at the time of exposure.

The first element is supported by suction via a plurality of first element negative pressure suction holes provided on the outer edge of the second element.

Each negative pressure suction hole provided in the first element has a diameter equal to or different from the diameter of each negative pressure suction hole provided in the second element. One or more of the negative pressure suction holes of the first element are provided for respective one of the negative pressure suction holes of the second element.

The third element is provided with a header for collectively connecting a large number of negative pressure suction holes to a negative pressure suction source. The header may have a structure divided into at least two portions, such that it can switch regions for suction according to the size of the board, or it can be connected to a plurality of negative pressure suction sources.

In the board supporting stage for the exposure system formed of at least three flat-plate elements as described above, the readily detachable first element is provided with the negative pressure suction holes prearranged to avoid overlap with the through holes of the board. Thus, even when the type of the board changes, replacement of only the first element can eliminate the possibility of suction of air via the through holes of the board. Accordingly, easy and reliable replacement of the element of the board supporting stage for the exposure system is enabled.

According to another aspect of the present invention, the board supporting stage for the exposure system is provided with a flat-plate element for supporting the board on its plane in tight contact by exerting suction on the board via a large number of negative pressure suction pads provided on the plate.

Preferably, the flat-plate element includes a first element having an upper surface contacting the board, and a second element provided in contact with an under surface of the first element. The second element is provided with negative pressure suction pads in a given number of places. The fist element is provided with a pad through hole for letting the negative pressure suction pad penetrate therethrough, in the region where it is prevented from overlapping the through holes provided in the board to suppress suction of air via the board through holes, and exclusively in the position where it is desired to exert suction on the board via the negative pressures suction pad.

Further, the board suction surface of the negative pressure suction pad is shaped and sized such that it penetrates through the pad through hole provided in the first element and expands and contracts between the position where it can exert suction on the board and the position at the same level as the upper surface of the second element. A third element is provided in contact with the under surface of the second element, and has a header function for collectively connecting the negative pressure suction pads provided in the second element to a suction source.

When the negative pressure suction pads are employed as described above, exertion of suction on the board is ensured even if the board is warped or distorted. Thus, the board can be secured on the first element reliably.

### Brief Description of the Drawings

Fig. 1 is a top plan view showing the board supporting stage according to a first embodiment of the present invention.
Fig. 2 is a cross sectional view taken along the line X-X' in Fig. 1.
Fig. 3 is an enlarged cross sectional view of an encircled region A in Fig. 2.
Figs. 4A-4F illustrate how the through holes for exerting suction on the substrate are formed in the first element avoiding overlap with the through holes of the substrate.
Fig. 5 is a first cross sectional view showing the board supporting stage according to a second embodiment of the present invention.
Fig. 6 is a second cross sectional view showing the board supporting stage of the second embodiment.
Fig. 7 is a top plan view showing the board supporting stage of the second embodiment.
Fig. 8 is a cross sectional view taken along the line X-X' in Fig. 7.
Fig. 9A is a top plan view showing another embodiment of the negative pressure suction pad, and Fig. 9B is its cross sectional view corresponding to the first cross sectional view shown in Fig. 5.

### Best Modes for Carrying out the Invention

### First Embodiment

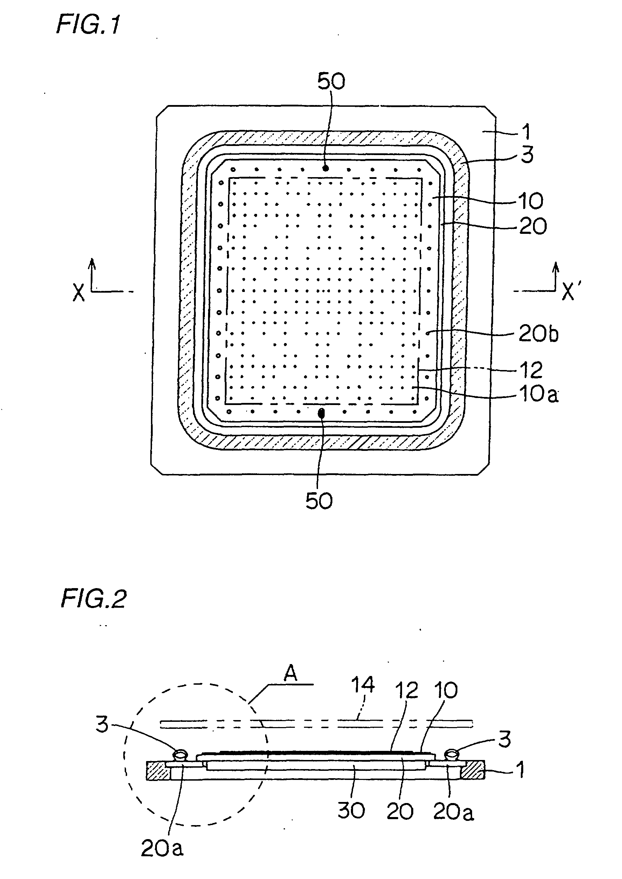

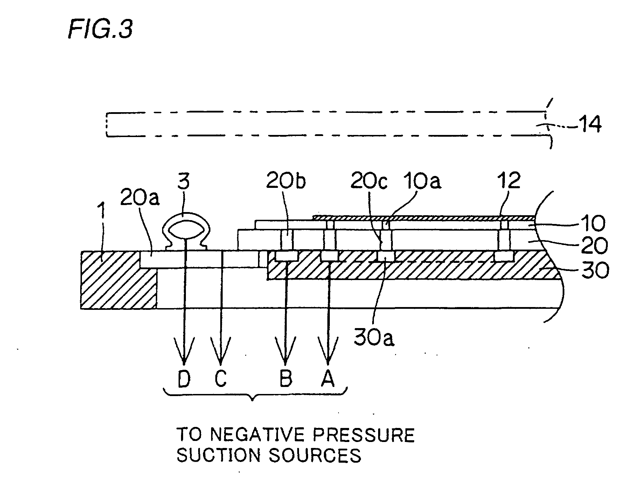

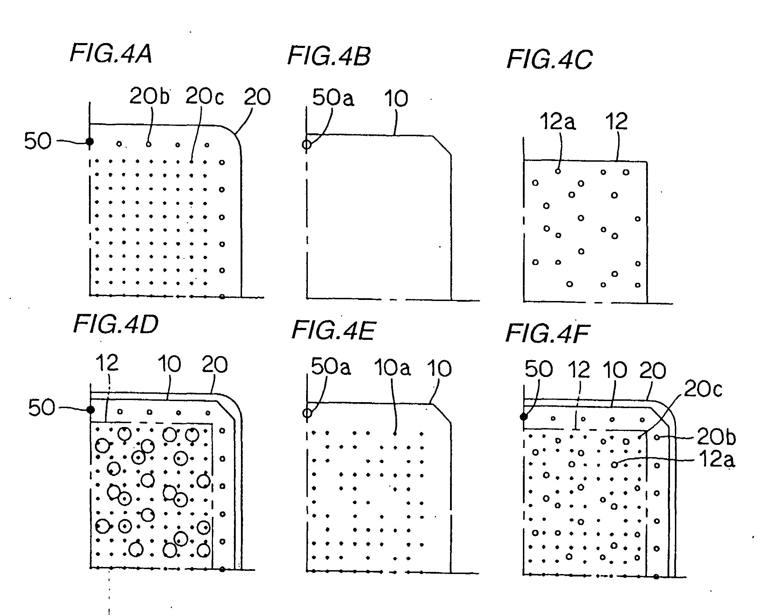

Hereinafter, the board supporting stage for an exposure system according to the first embodiment of the present invention will be described with reference to the drawings. Fig. 1 is a top plan view showing the board supporting stage, Fig. 2 is a cross sectional view taken along the line X-X' in Fig. 1, Fig. 3 is an enlarged cross sectional view of the encircled region A in Fig. 2, and Figs. 4A-4F illustrate, for a quarter area to the upper right of the plan view in Fig. 1, the procedure of forming holes in the board supporting stage.

The board supporting stage shown in Figs. 1-3 is premised on the one being provided to an exposure station of the exposure system in which a photomask and a board are stacked one on another in proximity or in contact with each other and the board is irradiated with light through the photomask such that the pattern drawn on the photomask is transferred onto the board. The detailed description of the structures of exposure system and exposure station will not be provided here, since conventionally known structures can be adopted.

### <Details of Board Supporting Stage>

Referring to Figs. 1-3, the second element 20 bearing against a frame body 1 has a peripheral member 20a bonded to second element 20. Hollow seals 3 are mounted on peripheral member 20a to ensure vacuum contact between a photomask 14 and a board 12 before exposure. A third element 30 is bonded to the under surface of second element 20 by means of adhesive or the like. Second element 20 is made of a plastic plate, while third element 30 is made of an elastic body such as rubber.

Second element 20 is provided with locating pins 50 in two places, which are positioning elements for registration of first element 10.

The number of locating pins 50 is selected as desired. A stopper or the like may be provided instead of locating pin 50.

Second element 20 is further provided with first element suction holes 20b, on its periphery, as negative pressure suction holes for supporting first element 10 by suction, and board suction holes 20c, over the entire surface inwards, as negative pressure suction holes for supporting board 12 by suction via first element 10. Suction holes 20b and 20c are arranged in predetermined places.

The top plan view of Fig. 1 shows first element 10 stacked on second element 20, and also shows, by a double dotted and dashed line, an outline of board 12 to be stacked thereon. First element 10 is provided with board suction holes 10a as negative pressure suction holes that are formed in regions except for the regions where board through holes 12a (see Fig. 4C) are provided in board 12. First element 10 may be a plastic flat plate, plastic sheet, or plastic film.

The board supporting stage consisting of first element 10, second element 20 and third element 30 having such a flexible structure facilitates establishment of tight contact between the photomask and the board by negative pressure at the time of exposure.

Fig. 3, the enlarged cross sectional view of the encircled region A in Fig. 2, shows the configuration of the board supporting stage in detail. Third element 30 is provided with negative pressure suction ports A and B for exerting suction on the peripheries of board 12 and first element 10. Peripheral member 20a of second element 20 is provided with hollow seals 3 for achieving, by negative pressure, tight contact between photomask 14 and board 12 supported by the board supporting stage, and is further provided with a negative pressure suction port C for suction under negative pressure of the space created between the board supporting stage and the photomask. Hollow seal 3 is provided with a negative pressure suction port D for adjustment of its height by causing negative pressure within the hollow portion.

Negative pressure suction ports A-D may be connected respectively to separate negative pressure suction sources. Alternatively, a header structure 30a divided into at least two sections may be adopted to allow switching of regions for suction according to the size of board 12, or to make itself connectable to a plurality of negative pressure suction sources.

Negative pressure suction hole 10a of first element 10 for exerting suction on board 12 by negative pressure may have a diameter equal to or different from that of negative pressure suction hole 20c provided in second element 20. Preferably, one or more suction holes 10a are provided for respective one of suction holes 20c.

With the board supporting stage configured as described above, suction of air via board through holes 12a (see Fig. 4C) is prevented when board 12 is supported, so that the drawback of the conventional case is removed.

### <Exposure Process with Board Supporting Stage>

Described hereinafter is the operation of each portion of the board supporting stage having the structure and function as described above, in the exposure process wherein board 12 is supported and irradiated with light through photomask 14 for transfer of the pattern (not shown) drawn on photomask 14 onto board 12.

First element 10 of the board supporting stage, provided in advance with board suction holes 10a for exerting suction on board 12, is aligned with and rested on second element 20 using locating pins 50 provided on second element 20.

First element 10 is secured on the upper surface of second element 20 by developing negative pressure via first element suction holes 20b provided on the periphery of second element 20.

When such preparation is completed, board 12, being held by a suction pad or the like (not shown) from above, is carried in and positioned above the board supporting stage. At this time, negative pressure is developed via board suction holes 10a of first element 10 for exerting suction on board 12, so that board 12 is secured by suction on the upper surface of first element 10.

Next, photomask 14 is brought closer to board 12 for alignment thereof. At this time, negative pressure is developed within hollow seal 3 to reduce its height, which is controlled to prevent contact between hollow seal 3 and photomask 14.

When the alignment is completed, photomask 14 and board 12 are brought into contact with each other. The negative pressure in hollow seal 3 is released, so that it also comes into contact with photomask 14. Negative pressure is then applied from negative pressure suction port C, so that tight contact is established between photomask 14 and board 12 by the negative pressure.

In this state, board 12 is exposed to light through photomask 14, so that the pattern (not shown) drawn on photomask 14 is transferred onto board 12. (Here, a graphical representation is not provided for the alignment of photomask 14 and board 12 or for the exposure.)

After the pattern transfer, the negative pressure of suction port C is released, negative pressure is developed inside hollow seal 3 again to reduce its height, and the tight contact by the negative pressure between photomask 14 and board 12 is broken. Thus, photomask 14 and board 12 are separated from each other.

The negative pressure of suction port A is then released. Board 12 now removable from first element 10 is carried out while being held by the suction pad or the like (not shown) from above, to be subjected to a next process. The operations described above are repeated subsequently.

As described above, in the board supporting stage used for the exposure process, board suction holes 10a of first element 10 for exerting suction on board 12 are formed avoiding overlap with board through holes 12a of board 12. Accordingly, suction of air via board through holes 12a, and hence, reduction of the negative pressure is prevented. This ensures strong suction on and thus firm support of board 12 by the board supporting stage.

Further, as described above, even if photomask 14 and board 12 are brought closer to each other, negative pressure is not developed in the gap therebetween. Accordingly, it is possible to stably maintain a prescribed gap between photomask 14 and board 12.

### <Forming Method of Board Suction Holes>

Now described with reference to Figs. 4A-4F is how board suction holes 10a for exerting suction on the board are formed in the first element avoiding overlap with board through holes 12a. To facilitate the understanding, Figs. 4A-4F each show only a quarter area to the upper right of the top plan of the board supporting stage shown in Fig. 1.

Of Figs. 4A-4F, Fig. 4A shows second element 20. Fig. 4B shows first element 10 provided with no holes except those for locating pins 50a. Fig. 4C shows board 12 provided with board through holes 12a. Fig. 4D shows such second element 20, first element 10 and board 12 being stacked one on another. It also shows identical circular regions provided about respective board through holes 12a of board 12.

Fig. 4E shows first element 10 provided with board suction holes 10a that are formed at the same positions as board suction holes 20a of second element 20 except for those falling within the circular regions provided about respective board through holes 12a shown in Fig. 4D.

Fig. 4F shows second element 20, first element 10 of Fig. 4E stacked thereon, and board 12 of Fig. 4C further stacked thereon. It can be seen that no board suction hole 10a of first element 10 is provided in the proximity of board through hole 12a of board 12.

The above-described method of forming board suction holes 10a in first element 10, by first stacking those of Figs. 4A-4C one on another, setting the circular regions about board through holes 12a in board 12, and then forming the holes 10a at the same positions as board suction holes 20c in second element 20 except for those falling within the circular regions, can be effected, upon receipt of data showing the positions of board suction holes 20c in second element 20, board through holes 12a in board 12, and the regions provided about through holes 12a, by processing these data with a program for determining where the negative pressure suction holes 10a should be formed in first element 10. This program may be executed on a general-purpose computer or a dedicated processor.

Preferably, a dedicated driller or the like is then used to form board suction holes 10a in first element 10 at the positions determined based on the output data obtained as the result of processing.

### Second Embodiment

In the first embodiment described above, board 12 is secured on the board supporting stage by suction being exerted on board 12 via board suction holes 10a provided in first element 10. Board 12, however, is not necessarily flat. If board 12 is warped or distorted, a gap would be created between board 12 and first element 10. In such a case, negative pressure suction holes 10a provided in the plane of first element 10 alone might be insufficient for strong suction to be exerted on board 12.

Thus, in the present embodiment, negative pressure suction pads are provided, which work on the plane level of first element 10 to ensure suction on, and hence, holding of board 12 by first element 10, even if board 12 is distorted.

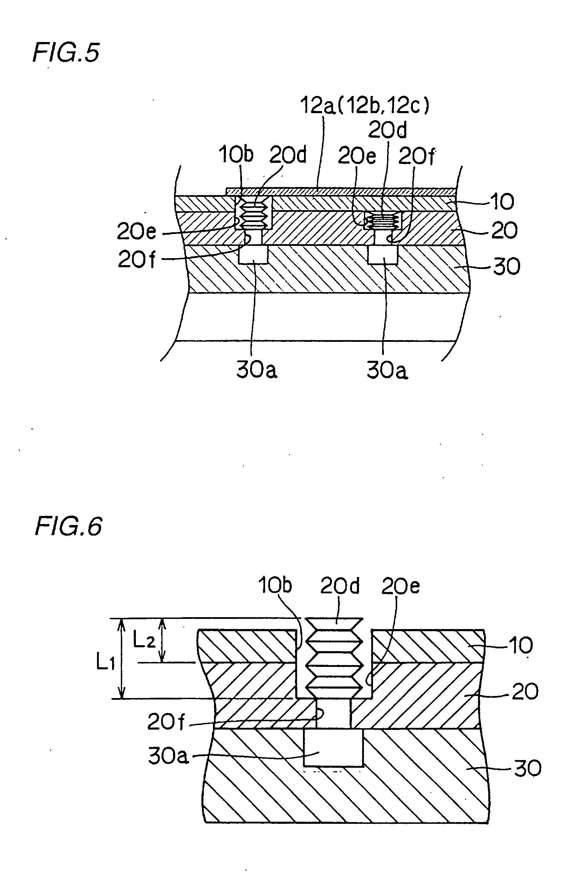

Hereinafter, the board supporting stage for an exposure system provided with the negative pressure suction pads according to the second embodiment of the present invention will be described with reference to Figs. 5 and 6. Fig. 5 shows the structure in cross section in the state where suction is being exerted on the board. Fig. 6 shows the structure in cross section in the state where suction is not being effected.

Negative pressure suction pad 20d has an accordion structure of a cylindrical shape. It is formed of an elastic body and retractable.

A plurality of negative pressure suction pads 20d are provided in arbitrary places of second element 20. First element 10 is provided with pad through holes 10b allowing negative pressure suction pads 20d to penetrate therethrough. The holes 10b are arranged avoiding overlap with through holes provided in board 12 to prevent suction of air via the board through holes, and only in the regions where suction is desired to be exerted on board 12 via the negative pressure suction pads 20d.

Second element 20 is provided with pad setting holes 20e for embedding negative pressure suction pads 20d therein, and through holes 20f in communication with these pad setting holes 20e.

Third element 30 is provided in contact with the under surface of second element 20. Headers 30a are provided to third element 30 in predetermined positions for collectively connecting negative pressure suction pads 20d provided in second element 20 to a negative pressure suction source.

As shown in Fig. 6, negative pressure suction pad 20d in a state of free length (L1) has its board suction surface at the level upper than first element 10 (by 0.5 mm to 3.0 mm). It penetrates through pad through hole 10b in first element 10 and exerts suction on board 12. The pad 20d is shaped and sized such that it is retractable (by L2) to the level of the upper surface of second element 20.

Provision of such negative pressure suction pads 20d ensures secure holding of board 12 even if the board 12 is distorted.

Positions for providing negative pressure suction pads 20d can be determined in the same manner as those of negative pressure suction holes 10a and board suction holes 20c in the first embodiment. Alternatively, they may be provided exclusively in the peripheral region of the board where the board through holes are relatively sparse.

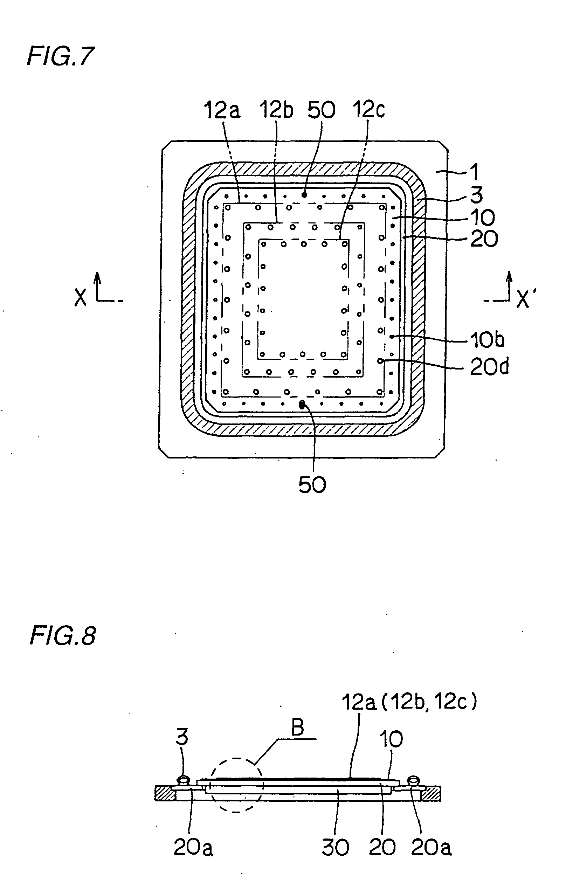

For example, as shown in Figs. 7 and 8, negative pressure suction pads 20d may be provided, according to the size of board 12a, 12b or 12c, in the region corresponding to the periphery of the relevant board.

Although negative pressure suction pads 20d may be provided alone, it is more preferable if they are used together with negative pressure suction holes 10a as in the first embodiment.

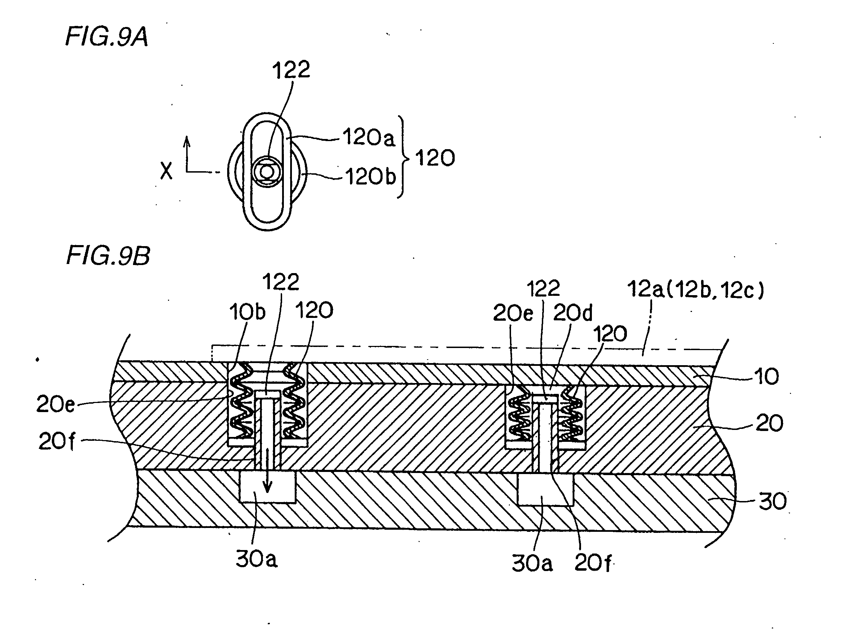

Negative pressure suction pad 20d described above is of a circular shape in two dimensions. However, from the standpoint of improving suction efficiency on the board, negative pressure suction pad 120 as shown in Figs. 9A and 9B may be employed, which has its suction plane 120a contacting the board in an oval shape, and has its body in a circular cylindrical shape.

Further, an inserter 122 may be provided within the negative pressure suction pad 120, as shown in Figs. 9A and 9B, for the purpose of preventing inward deformation of the pad 120 while suction is being exerted on the board. Inserter 122 is equally effective if it is provided in the negative pressure suction pad 20d of the shape as shown in Figs. 5 and 6.

Provision of such oval-shaped suction pads 120 along the sides of the board makes it possible to narrow the free space required on the periphery of the board.

Although each embodiment described above has a structure with three flat-plate elements for cost saving and simple manufacturing, the number of the elements is not necessarily limited to three, which can be changed where appropriate.

Accordingly, it should be understood that the embodiments herein disclosed are solely illustrative and non-restrictive by all means. The scope of the present invention is defined, not by the description above, but by the scope of claim for patent, wherein any modification within the meaning and range equivalent thereto is intended to be included.

As described above, without provision of the board supporting stage based on the present invention, the techniques conventionally employed to prevent suction of air via the board through holes, i.e., filling with filler or the like the negative pressure suction holes of the board supporting stage overlapping the through holes of the board, or collectively connecting a plurality of suction holes to one header, establishing a large number of suction systems connected to a negative pressure suction source via valves, and controlling opening/closing of the valves so as to restrict suction of air through the board through holes to a least possible level, were inadequate, taking a lot of trouble with replacement of elements of the stage.

By comparison, according to the board supporting stage of the present invention, it is possible to reliably suppress suction of air via the board through holes, and thus, to prevent reduction of the negative pressure. Accordingly, the board can be firmly supported by the board supporting stage by suction.

In addition, when the photomask and the board are brought closer to each other, a predetermined gap therebetween can be stably maintained, since negative pressure is not developed in the gap. The negative pressure suction holes for exerting suction on the board can be prearranged in the first element according to the type of the board. This simplifies the replacement of the element, removing the drawbacks of the conventional case, thereby greatly contributing to improvement of productivity.

Further, provision of the negative pressure suction pads allows strong suction to be exerted on even a distorted board, and therefore, the board can be secured on the first element without fault.

## Claims

1. A board supporting stage provided in an exposure system wherein a photomask and a board are stacked one on another in proximity or in contact with each other and said board is irradiated with light through said photomask for transfer of a pattern drawn on said photomask onto said board, said board supporting stage comprising:
negative pressure suction means for supporting said board in tight contact on a plane, said negative pressure suction means being provided avoiding a region where a board through hole is provided in said board to prevent suction of air via said board through hole.

2. A board supporting stage for an exposure system wherein a photomask and a board are stacked one on another in proximity or in contact with each other and said board is irradiated with light through said photomask for transfer of a pattern drawn on said photomask onto said board,
said board supporting stage comprising:
a flat-plate element supporting said board on a plane thereof by exerting suction on said board via a great number of negative pressure suction holes provided in said plane to bring said board into tight contact with said plane,
said flat-plate element including
a first element having an upper surface contacting said board, and a second element provided in contact with an under surface of said first element, said first and second elements being formed of flat plates each provided with the negative pressure suction holes for exerting suction on said board in positions corresponding to each other,
said negative pressure suction holes of said first element being arranged avoiding overlap with board through holes provided in said board, and
a third element provided in contact with an under surface of said second element, said third element having a header function for collectively connecting said negative pressure suction holes provided in said first and second elements to a negative pressure suction source.

3. The board supporting stage for the exposure system according to claim 2, wherein said negative pressure suction holes provided in said first element are through holes that are formed, upon receipt of data showing positions of said negative pressure suction holes provided in said second element, data showing positions of said board through holes provided in said board, and data showing regions encircling said board through holes, by executing on a general-purpose computer or a dedicated processor a program for processing the data for determination of the positions in said first element where said negative pressure suction holes are to be formed, and forming the holes with a driller based on output data obtained as a result of the data processing.

4. The board supporting stage for the exposure system according to claim 2, wherein a positioning element such as a pin or stopper is used for alignment of said first and second elements, such that the positions of respective said negative pressure suction holes provided in said first element match the positions of corresponding said negative pressure suction holes provided in said second element.

5. The board supporting stage for the exposure system according to claim 2, wherein
said first element is formed of a plastic flat plate, plastic sheet or plastic film,
said second element is formed of a plastic flat plate,
said third element is formed of an elastic body like rubber, and
said third element is bonded to said second element with adhesive.

6. The board supporting stage for the exposure system according to claim 2, wherein said first element is supported by suction via a plurality of first element suction holes provided on an outer edge of said second element.

7. The board supporting stage for the exposure system according to claim 2, wherein said negative pressure suction hole of said first element for exerting suction on said board by negative pressure has a diameter equal to or different from a diameter of said negative pressure suction hole provided in said second element, and one or more of said negative pressure suction holes of said first element are provided corresponding to respective one of said negative pressure suction holes of said second element.

8. The board supporting stage for the exposure system according to claim 2, wherein said header provided in said third element has a structure divided into at least two portions, to allow said header to switch suction regions according to the size of said board, or to make said header connectable to a plurality of said negative pressure suction sources.

9. A board supporting stage for an exposure system wherein a photomask and a board are stacked one on another in proximity or in contact with each other and said board is irradiated with light through said photomask for transfer of a pattern drawn on said photomask onto said board,
said board supporting stage comprising:
a flat-plate element supporting said board on a plane thereof by exerting suction on said board via a great number of negative pressure suction pads provided on the plane to bring said board into tight contact with said plane,
said flat-plate element including
a first element having an upper surface contacting said board, and a second element provided in contact with an under surface of said first element,
said second element being provided with said negative pressure suction pads in an arbitrary number of positions,
said first element being provided with a pad through hole for letting said negative pressure suction pad penetrate therethrough, in a region avoiding overlap with a board through hole provided in said board to prevent suction of air via said board through hole, and exclusively in a position where suction is desired to be exerted on said board via said negative pressure suction pad,
said negative pressure suction pad being shaped and sized such that a board suction plane thereof penetrates through said pad through hole of said first element and is retractable between a position where suction can be exerted on said board and a position at the same level as an upper surface of said second element, and
a third element provided in contact with an under surface of said second element, said third element having a header function for collectively connecting said negative pressure suction pads provided in said second element to a negative pressure suction source.

10. The board supporting stage for the exposure system according to claim 9, wherein a plurality of said negative pressure suction pads are provided in positions corresponding to peripheries of a plurality of boards of different sizes.

11. The board supporting stage for the exposure system according to claim 9, wherein
said first and second elements are provided with, in addition to said negative pressure suction pads, negative pressure suction holes for exerting suction on said board in positions corresponding to each other,
said negative pressure suction holes of said first element are positioned avoiding overlap with the board through holes provided in said board to prevent suction of air via said board through holes, and
said header function has a function to collectively connect said negative pressure suction holes provided in said first and second elements to the negative pressure suction source.

12. The board supporting stage for the exposure system according to claim 9, wherein said negative pressure suction pad has an oval shape at least in a region contacting said board.

13. The board supporting stage for the exposure system according to claim 9, wherein said negative pressure suction pad includes an inserter provided inside thereof.
